# EUROPEAN PATENT APPLICATION

(11) **EP 4 815 026 A1**
(43) Date of publication of application: **30.09.2026**
(21) Application number: 26159129.1
(22) Date of filing: 17.02.2026
(51) Int. Cl.: H01J 37/22, H01J 37/26

(54) **METHOD FOR FINDING OPTIMAL IMAGE CONTRAST WHEN USING A LASER PHASE PLATE**

(30) Priority: 11.03.2025 US 202519076715
(71) Applicant: FEI Company, Hillsboro OR 97124 (US)
(72) Inventor: HAGEN, Wim, Hillsboro, 97124-5793 (US); VOIGT, Andreas, Hillsboro, 97124-5793 (US); BUIJSSE, Bart, Hillsboro, 97124-5793 (US); ALTIN, Veli, Hillsboro, 97124-5793 (US)
(74) Representative: Boult Wade Tennant LLP

(57) **Abstract**

Phase contrast imaging in charged particle beam (CPB) systems is controlled by adjusting an undeviated component of a CPB to be at a predetermined location in a diffraction plane in which a phase plate such as a laser phase plate is situated. By scanning the undeviated CPB component in the diffraction plane and assessing image contrast or image spectra, alignment corresponding to the phase at the predetermined phase location can be confirmed and/or offsets corrected.

## Description

### FIELD

The disclosure pertains to phase contrast electron microscopy.

### BACKGROUND

Phase contrast microscopy offers numerous imaging advantages but implementing the necessary phase plates in charged particle beam (CPB) imaging can be challenging. One approach to producing the necessary phase changes in CPB imaging is based on a laser phase plate in which a periodic optical field of sufficient intensity is established to produce a suitable CPB phase shift based on the pondermotive potential associated with the periodic optical field. In most practical examples, the periodic optical field is established by directing a laser beam into a high finesse Fabry-Perot resonator to establish a standing wave optical field. Such systems are described in, for example, Axelrod, "A Laser Phase Plate for Transmission Electron Microscopy," available at https://arxiv.org/abs/2403.10870, submitted March 15, 2024, Axelrod et al., "Modern Approaches to Improving Phase Contrast Electron Microscopy," available at https://arxiv.org/abs/2401.11878, submitted January 22, 2024, Axelrod et al., U.S. Patent Application Publication US2018/0286631A1, and Glaeser et al., U.S. Patent Application Publication 2013/0037712A1, all of which are incorporated herein by reference. For successful imaging with a laser phase plate, the CPB must be directed to the standing wave optical field produced by the Fabry-Perot resonator. This standing wave optical field typically has a spatial extent defined by a lowest-order mode Gaussian beam mode having a beam waist selected so that the intensity of the standing wave optical field is sufficiently large to produce the intended pondermotive potential. Useful beam waists tend to be in a range from 2 µm to 10 µm. A length over which the standing wave optical field can be referred to as focused is about one Rayleigh range on either side of the standing wave optical field beam waist with typical values of Rayleigh range between 50 µ and 200 µm. With such mode dimensions, aligning and maintain alignment of the CPB with an antinode of the Gaussian beam mode can be challenging, requiring considerable user effort and methods and apparatus that facilitate alignment and maintaining alignment are needed.

### SUMMARY

Alignment of a phase plate such as a laser phase plate and a charged particle beam (CPB) such an electron beam can be assessed and adjusted by obtaining images at one or more locations and comparing image contrast or image spectra, with or without spatial frequency filtering. The CPB can be scanned in various patterns to obtain the images and the images evaluated based on mean or mean square image intensities. The CPB and phase plate can be re-aligned as needed based on the CPB position associated with a highest contrast image. CPB position at a phase plate situated in a diffraction or Fourier transform plane can be adjusted using one or more deflectors to provide a CPB tilt at a specimen. In some examples, the CPB tilt is provided so that the CPB position at the specimen is substantially unchanged by the tilt. Assessment and adjustment of CPB/phase plate positioning can be provided using one or more logic devices such a computer processor coupled to a beam deflector and/or a translation stage. CPB imaging systems can incorporate the disclosed approaches so that proper CPB/phase plate positioning can be maintained without operator intervention and without appreciable interference in specimen evaluation.

The foregoing and other features, and advantages of the disclosed technology will become more apparent from the following detailed description, which proceeds with reference to the accompanying figures.

### BRIEF DESCRIPTION OF THE DRAWINGS

FIGS. 1A-1B illustrate a charged-particle-beam (CPB) imaging system that includes a laser phase plate and a deflection system for establishing a selected alignment of the laser phase plate and a CPB axis.
FIGS. 2A-2C illustrate representative scan patterns use to determine alignment of a CPB with a laser phase plate.
FIG. 3 illustrates a Fabry-Perot resonator which produces a standing wave optical field having a Gaussian profile.
FIG. 4 illustrates a CPB axis arranged so that an undeviated beam portion is incident to an antinode location of a standing wave optical field.
FIG. 5 illustrates a CPB axis that is displaced from an antinode.
FIGS. 6A-6C are graphs of the variance of simulated cryo-EM images as a function of transverse offset of the CPB axis associated with an undeviated beam portion at a diffraction plane with phase modulation provided by a standing wave optical field of a laser phase plate.
FIG. 7 illustrates a representative method of establishing a CPB axis location with respect to a standing wave optical field of a laser phase plate.
FIG. 8 illustrates a representative computing environment for use with any of the disclosed methods or apparatus.
FIG. 9 illustrates a representative CPB imaging system that includes a control system that is operation for CPB/phase plate positioning and contrast calculations.
FIG. 10 illustrates a representative method in which a phase plate and CPB are intermittently aligned between image acquisitions.
FIGS. 11A-11D illustrate CPB images having different contrasts.
FIG. 11 E illustrates variance of image intensity associated with various images, including those of FIGS. 11A-11D.
FIGS. 12A-12B illustrated unfiltered and low pass filtered diffractograms associated with CPB/phase plate imaging.
FIGS. 12C-12D illustrate image intensity variances for the unfiltered and filtered images of FIGS. 12A-12B, respectively.
FIGS. 13A-13F are graphs of spatial frequency amplitudes of phase contrast images obtained with laser phase plate as a function of spatial frequency for differing CPB/laser phase plate alignments.
FIG. 13G illustrates the alignments associated with FIGS. 13A-13F.
FIG. 14 illustrates a representative alignment method using image spectra.

### DETAILED DESCRIPTION

The disclosure pertains to aligning a charged-particle beam to a laser phase plate or other phase plate to establish and maintain a preferred arrangement as desired for phase contrast imaging. The disclosed approaches can provide alignment of a CPB with respect to an optical beam such a standing wave optical field defined in a Fabry-Perot resonator so that the CPB interacts with the optical beam in a high field region. In addition, the disclosed approaches can provide alignment to nodes, antinodes, or other locations of the periodic phase pattern defined by the standing wave optical field.

### General Terminology

As used herein, "image" refers to visual presentation for viewing such by a technician, operator, or other person on display device, a projection on a surface such as projection screen, or otherwise presented for viewing. "Image" also refers to numerical representations of viewable images such as in image files in JPG, TIFF, BMP, or other formats. Such numerical representations include or are processable to produce values of intensity as a function of position, I(X,Y), wherein X and Y are coordinates along linearly independent (and typically orthogonal) axes. In the examples described herein, intensity is presented as a single value without reference to color as would be viewed by an observer. However, intensity values can be assigned to one or more spectral components such as red, green, and blue for viewing, or other image values such as hue, saturation, and value, or color coordinates (for example LAB, CYMK, RGB) can be used. In the examples, the images of interest are charged-particle beam (CPB) images, and a single intensity value is appropriate.

Numerical representations of images can be referred to sample location based on intensity values I(X,Y) for ranges of spatial coordinates. Alternatively, images can be represented as arrays or other sets of intensity values I(J,K), wherein J,K are nonnegative integers denoting pixel locations corresponding to sample locations. Mappings of pixel locations (J,K) to image coordinates (X,Y) depends on sample placement and image magnifications. In some cases, arrays of intensities I(J,K) are obtained with an array detector, but non-array detectors can also be used. Intensity is generally associated with charge or current at individual pixels and can be a linear or other function of charge or current. The examples are described with respect to right-handed Cartesian coordinate systems in which a Z-axis is generally associated with a CPB optical axis and X- and Y-directions are orthogonal to the Z-axis and are thus associated with transverse offsets.

Examples are described with reference to laser phase plates in which a standing wave optical field is established to produce suitable CPB phase shifts based on the pondermotive potential associated with the periodic optical field. In most practical examples, the standing wave optical field is established by directing a laser beam into a high finesse Fabry-Perot resonator to establish a standing wave optical field having sufficient peak intensity in the antinodes to produce a periodic CPB phase shift of sufficient amplitude. In some examples, the amplitude of the phase shift can be set as π/2, but other values can be chosen, and this value can be used for convenient explanation. Amplitude of a standing wave optical field in a Fabry-Perot resonator is described as a Gaussian beam, preferably in a lowest order mode, having a beam waist *w₀* that can be selected to provide a suitable beam intensity for production of the pondermotive potential. Linear optical resonators are convenient, but ring or other types of optical resonators can be used.

As used herein, a CPB is described as being directed along an axis toward a sample, a phase plate, and a detector such as an image detector. A displacement along the axis of a CPB diffraction plane from a location of the phase plate is referred to herein as a "diffraction plane displacement" represented as Δ and is generally illustrated along a Z-axis. Typically, a diffraction plane is located at a back focal plane of a CPB objective lens or at other optically conjugate location. Imaging with Δ = 0 can be referred to as "on-plane imaging" while imaging with non-zero values of Δ is referred to as "off-plane imaging." A displacement of a peak value or other specified value of phase (or antinode or other portion of a standing wave optical field in a laser phase plate) in a direction orthogonal to the axis is referred to herein as a transverse offset δ. A preferred transverse offset is typically associated with a peak value of phase associated with a phase plate (such as an antinode), but other locations can be used. As used herein, a phase plate is referred to as having a "phase axis" that is in a direction associated with variable phase shifts applied to an incident CPB. In a laser phase plate, the standing wave optical field defines phase variations associated with nodes and antinodes that are periodic along a direction that is transverse to a CPB axis or propagation, typical within, 2, 5, 10, or 15 degrees of normal incidence. The direction along which the standing optical field exhibits periodic variation between nodes and antinodes is thus the phase axis of the laser phase plate. In the examples, phase axes are typically illustrated as along an X-axis of a coordinate system used for description and the standing wave optical field is periodic along the X-axis with a CPB propagating along a Z-axis. Generally, diffraction plane displacements Δ from an objective lens back focal plane or other optical conjugate plane and transverse offsets in such a plane are used. It is convenient to set a diffraction plane displacement Δ and a transverse offset δ using one or more CPB optical components, but a phase plate can be translated as needed with respect to the CPB axis of propagation or the phase axis to produce intended diffraction plane displacements and transverse offsets.

Unless otherwise indicated, CPB axis refers to an axis along which an undiffracted or unscattered or otherwise undeviated CPB propagates from a specimen, or alternatively, along which a zero spatial frequency component associated with a specimen image propagates for detection. For convenience, the examples describe implementations using the undiffracted component or unscattered component and in typical examples the undiffracted or unscattered component is directed to be at or near an antinode of a periodic phase modulation produced associated with a laser phase plate. However, implementations can be based on other diffraction orders, scattered components, and spatial frequencies by directing these diffraction orders, scattered components, or spatial frequency components to suitable positions of the periodic phase modulation. For example, directing a 0^{th} diffraction order or a particular spatial frequency component or particular component of a CPB deviated by a specimen to a laser phase plate antinode can also be described as directing these components to be symmetrically situated about an antinode. Regardless of which diffraction orders, spatial frequencies, or arrangements of a scattered or deviated CPB component are selected, the disclosed approaches permit establishing a suitable alignment of a laser phase plate with respect to an optical standing wave field and/or maintaining and correcting such alignment.

A phase plate is preferably situated at a diffraction plane or Fourier transform plane of a CPB optical system typically established as back focal plane of one or more CPB lenses or a location that is optically conjugate to such locations. However, deviations from such placement can produce acceptable phase contrast images. As used herein, a plane or other location is referred to as "proximate" such a diffraction plane or Fourier transform plane when situated so that an unscattered or zero spatial frequency component (or other component of interest) is subject to a phase shift applied by a phase plate that varies by less than 2%, 5%, 10%, or 20% over the spatial extent of the component.

The examples are described using a laser phase plate that provides a periodic phase modulation along an axis of a standing wave optical field, but other types of phase plates can be used. In the description, CPB axes are generally referred to as associated with location of a CPB that is undeviated by a specimen at a diffraction plane but the CPB axis can be situated at other locations as well. A phase plate need not provide a periodic phase modulation, and the disclosed approaches permit alignment of phase plates for any type of phase modulation, not just the periodic phase modulation produced by a laser phase plate. It will be appreciated that a laser phase plate is defined by an optical field but is referred to as a "plate" for convenience.

As used herein, "orthogonal" angles refer to angles that are 90 degrees ±1, ±5, ±10, or ±15 degrees.

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatuses are referred to as "lowest", "best", "minimum," or the like. It will be appreciated that such descriptions are intended to indicate that a selection among many used functional alternatives can be made, and such selections need not be better, smaller, or otherwise preferable to other selections. Examples are described with reference to directions indicated as "above," "below," "upper," "lower," and the like. These terms are used for convenient description, but do not imply any particular spatial orientation. Specific coordinate systems are used for explanation only.

### Example 1

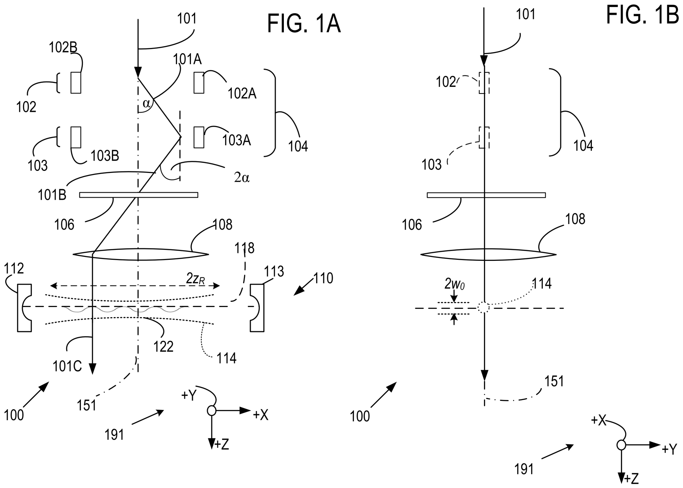

Referring to FIGS. 1A-1B. a CPB phase contrast imaging system 100 includes a CPB source that directs a CPB 101 along an axis 151. A CPB deflection system 104 includes a first deflector 102 illustrated as deflection plates 102A, 102B and a second deflector illustrated as deflection plates 103A, 103B situated optically downstream of the first deflector 102. In FIGS. 1A-1B, deflectors are illustrated as electrostatic deflectors but in typical implementations, deflection coils are used. The first deflector 102 deflects the CPB 101 away from the axis 151 in an XZ-plane of a coordinate system 191 by an angle α along an axis 101A. The second deflector 103 deflects a CPB propagating along the axis 101A by an angle 2α to propagate along an axis 101B to a specimen 106 so that the CPB 101 propagates to the specimen at an angle α and is incident to the specimen 106 at the same location as the CPB 101 without deflection, i.e., at a location associated with the undeflected axis 151. It is generally convenient to arrange the CPB deflection so that the CPB 101 is tilted and unshifted at the specimen 106. In such configurations, the CPB 101 tilt with respect to the (undeflected) CPB axis 151 can be referred to as a "pure" tilt. Upon interaction with the specimen 106, an undeviated component propagates along the axis 101B to an objective lens 108 which directs the undeviated component along an axis 101C to a laser phase plate 110. The laser phase plate 110 includes mirrors 112, 113 that form a Fabry-Perot resonator in which an optical standing wave field produces a periodic CPB phase shift illustrated at 118 having a spatial shape corresponding to (preferably), a lowest order Gaussian beam 114 having a beam waist *w₀* and a Rayleigh range *z_{R}*. Due to the dependence of CPB phase shift on the intensity of the standing wave optical field, the axis 101C is preferably directed to the standing wave optical field with one Rayleigh range on either side of the beam waist *w₀* at 122 and within the beam waist *w₀* and centered on an antinode.

The standing wave optical field produced between reflectors 112, 113 provides a periodic phase modulation to a CPB. To produce a higher contrast phase image, the axis 101C is generally arranged to be incident to the laser phase plate 110 at a location associated with an antinode of the phase modulation. In this example, the deflection system 104 provides appropriate beam direction so that an undeviated CPB portion is incident to the antinode location. Other arrangements can be used, such as incidence to a location associated with a node or to a location midway between a node and an antinode or at other locations. In addition, while alignment of a an undeviated CPB portion is typically intended, any diffraction order or spatial frequency component or other deviated CPB portion can be selected for direction to a location associated with a particular phase provided by the laser phase plate. The period *P* of the phase modulation is based on the wavelength of the standing wave optical field which is typically in a range of between about 500 nm and 1800 nm. Thus, small changes in CPB position with respect to the standing wave optical field can produce undesirable changes in imaging.

### Example 2

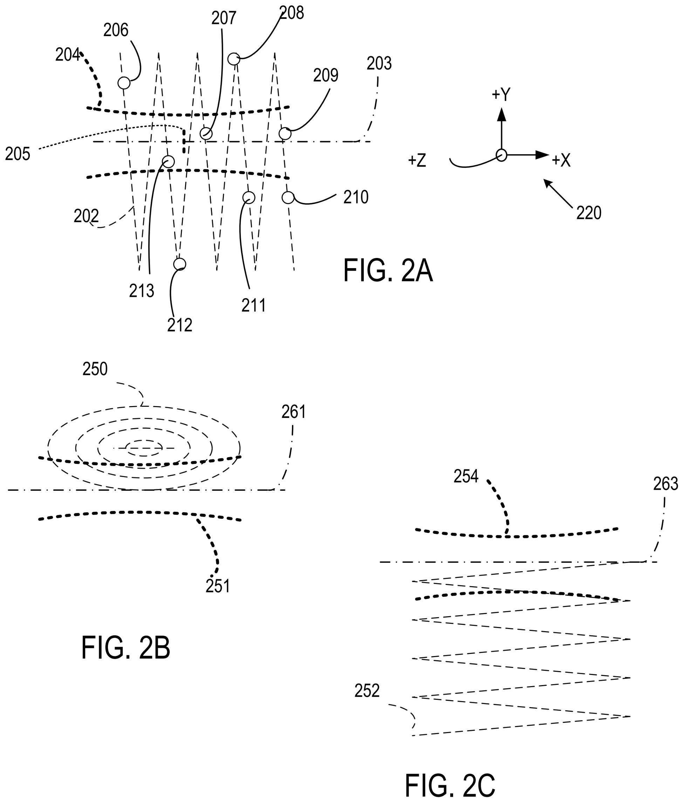

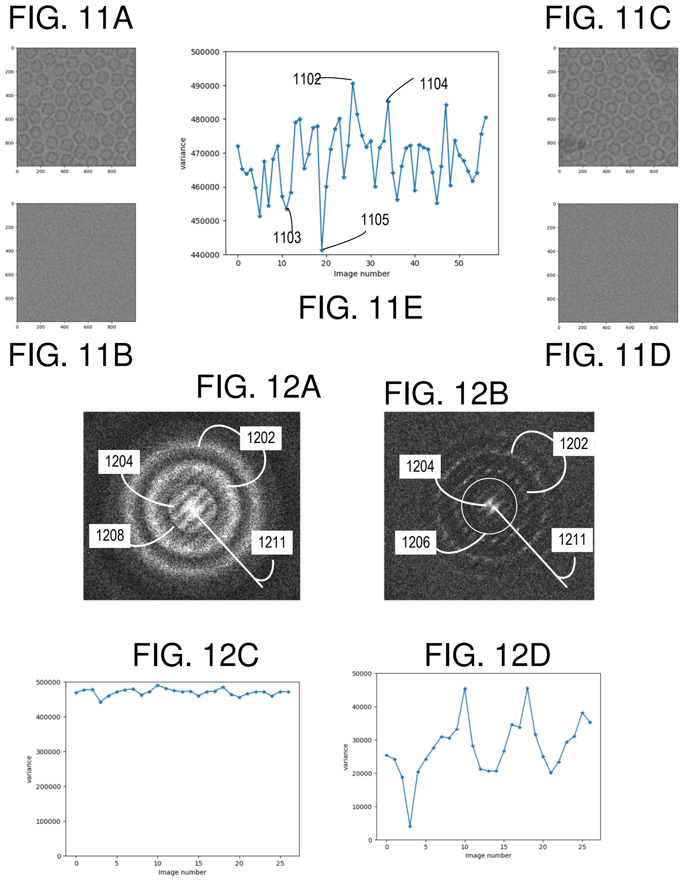

As shown in FIG. 1, CPB deflectors are situated to direct a CPB so that a undeviated CPB portion is incident to a selected location at a laser phase plate. Thus, the CPB and the standing wave optical field are preferably aligned so that the selected CPB component is incident to a high field region, i.e., within a beam waist, and to a selected location with respect to the standing wave optical field. Alignment can be determined by directing the undiffracted CPB along one or more axes to be incident at corresponding locations of the standing wave optical field. For example, FIG. 2A shows a CPB scan pattern 202 with respect to Gaussian beam 204 associated with a standing wave optical field of a laser phase plate situated at a diffraction plane and defining a defines a phase axis 203. In a coordinate system 220, a CPB axis is generally along a Z-axis into a plane of the drawing while a CPB phase produced by the Gaussian beam is periodic along the phase axis 203 that is parallel to an X-axis of a coordinate system 220. Specimen images can be obtained at one or more locations 208-213 defined by the CPB scan pattern 202. Image contrast for the obtained images is calculated and a location associated with a highest or relatively high contrast selected as a location of an antinode. In some cases, the locations 208-213 at which images are acquired do not exhibit an intended contrast. For example, all locations may be associated with nodes of the standing wave optical field so that images are of low contrast. The scan pattern can be repeated by adjusting to be offset by *P*/8, *P*/4*, P*/2 or other distance along the phase axis 203 (along the X-axis) to shift the pattern with respect to the nodes and antinodes of the periodic phase. Alternatively, the scan pattern and associated images can be arranged to be spaced by *P*/8, *P*/4, *P*/2 or other distance parallel to the phase axis whose direction is known Other representative scan patterns 250, 252 are illustrated in FIGS. 2B-2C with respect to respective Gaussian beams 251, 254 defining respective phase axes 261, 263.

Scan patterns of various shapes and sizes can be used such a raster scans, spiral scans, scans defined by circular, elliptical, or polygonal patterns, including multiples of different sizes, orientations, and offsets. Scans can also be determined based on random selection of CPB/phase plate relative offsets, and scans can be along a single axis or in multiple directions. Images can be acquired at some or all locations defined by a scan pattern.

### Example 3

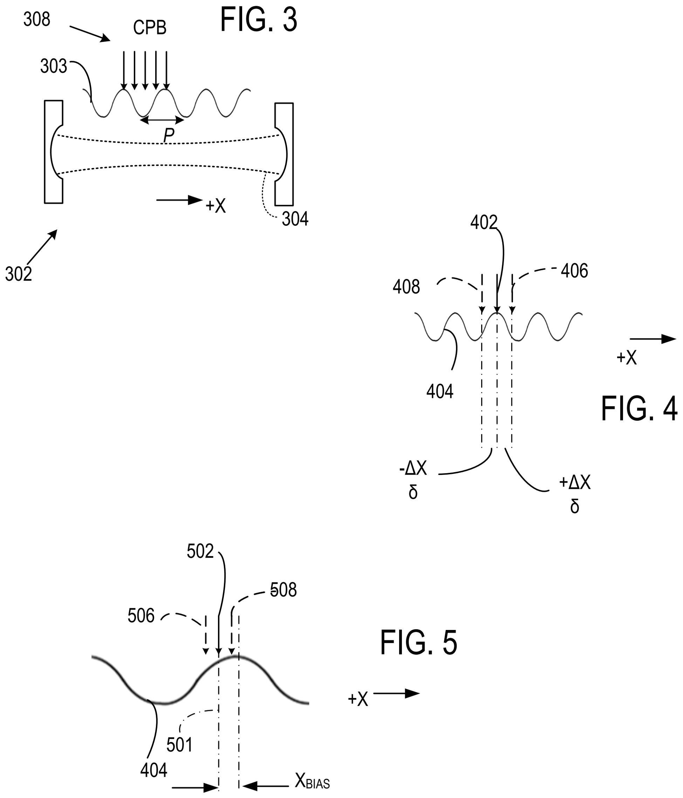

In cases in which the phase axis has been located, a linear scan along the phase axis can be used to acquire images that permit determination of the locations of one or more nodes or antinodes of the periodic phase pattern. A relatively long scan along the phase axis can be helpful in aligning the diffracted beam so that the undeviated CPB component is within the Rayleigh range *z_{R}* from the beam waist at a diffraction plane. FIG. 3 illustrates a Fabry-Perot resonator 302 which produces a standing wave optical field 303 having a Gaussian profile 304. Representative CPB axes 308 are illustrated, spaced apart along an X-axis to span a period *P* of the periodic phase associated with a laser phase plate. An image with a greatest contrast can be designated as corresponding to an antinode. Alternatively, images can be acquired at one or more additional axes displaced from a designated location, and an image with the greatest contrast is selected as corresponding to an antinode. This process can be repeated to provide a finer estimate of antinode location. This procedure can also be based on images with the lowest phase contrast to identify nodes, or images with both highest and lowest contrast can be used to estimate location of antinodes and nodes. Such images can be acquired periodically, randomly, at fixed or irregular intervals during operation to keep the CPB properly aligned with the periodic phase modulation.

### Example 4

With an undeviated CPB component aligned to interact with an antinode of the periodic phase, a displacement of the undeviated CPB component from the antinode is associated with lower image contrast. Such a displacement due to magnetic hysteresis effects in the optical system, component drift, charging, or other system changes results in this lower image contrast. However, a displacement from alignment in either direction produces similar lower contrast. To restore alignment, an image associated with an additional displacement, preferably of magnitude similar to that corresponding to the lowered contrast is selected. This displacement is applied in a known direction and image contrast at this displacement is determined. If the additional image exhibits still lower contrast, a corrective displacement is applied in a direction opposite that in which the additional displacement was applied. If the additional image has higher contrast, a corrective displacement is applied in the same direction as that of the additional displacement. In this way, the position of the undeviated CPB component can be maintained during operation and without appreciable operator input.

Referring to FIG. 4, a CPB axis 402 is arranged so that an undeviated CPB component order is incident to an antinode location of a standing wave optical field applied by, for example, a laser phase plate. For purposes of illustration, the CPB axis 402 is illustrated with respect to a graph 404 representing the periodic phase available with the laser phase plate. Specimen images are acquired with this axis and during operation, image contrast is occasionally, periodically, or randomly evaluated. Upon determining that image contrast is reduced and that the reduction is associated with either CPB axis 406 associated with a displacement +ΔX (a transverse offset δ) from the CPB axis 402 or a CPB axis 408 associated with a -ΔX displacement from the CPB axis 402 (a transverse offset -δ). To determine the appropriate direction of ΔX, an additional CPB axis is established based on a displacement in a known direction, for example, a displacement +δX. If image contrast of an image associated with the displacement +δX is increased, then the displacement ΔX is determined to be in the -X direction, i.e., -ΔX. If the image contrast is further reduced, the image displacement ΔX is determined to be in the +X direction, i.e., +ΔX. In either, an appropriate correction can be applied and the CPB axis returned to alignment with an antinode.

### Example 5

In another approach, a CPB axis is aligned slightly displaced from an antinode so that displacement during operation can result in either an increase or decrease in image contrast and which can unambiguously determine the displacement direction. Such a displacement can be referred as a bias. As shown in FIG. 5, a preferred CPB axis 502 is displaced from an antinode a distance X_{BIAS}. If image contrast is subsequently determined to have decreased, the displacement is in a direction further from the antinode such as along an axis 508. If image contrast in increased, the displacement is in a direction toward the antinode such as along an axis 508. Based on these determinations, a CPB axis can be restored to its preferred position.

### Example 6

Displacement of a CPB axis from a preferred location with respect to a laser phase plate can be determined based on image contrast in phase images. Image contrast can be assessed using a variance of image intensities or a function of variance such as a square root of variance, or in other ways, such as a mean of an absolute value of image intensity difference from the mean, or other measures. For an image consisting of an array or set of intensity values *I_{JK},* wherein *J*, *K* are non-negative integers, Var(*I*) or other function of Var(*I*) can be used. Alternatively, image contrast can be assessed based on a mean value of |*I_{JK}* -*I̅*|*.* Mean values of squared deviation from the mean and mean values of |*I_{JK}* - *I̅*| are convenient but sums of squared deviations from the mean and sums of |*I_{JK}* - *I̅*| can also be used. In typical phase contrast imaging, higher contrasts are preferred and an undeviated CPB component is directed to an antinode of the periodic phase. However, other selections can be made such as arrangements with reduced contrast (undeviated CPB component at *P*/4 from an antinode) or inverted contrast (undeviated CPB component at a node of the periodic phase). Filtering can be applied to the image, such as a band-pass filtering, to select the frequency band where most contrast improvement is expected.

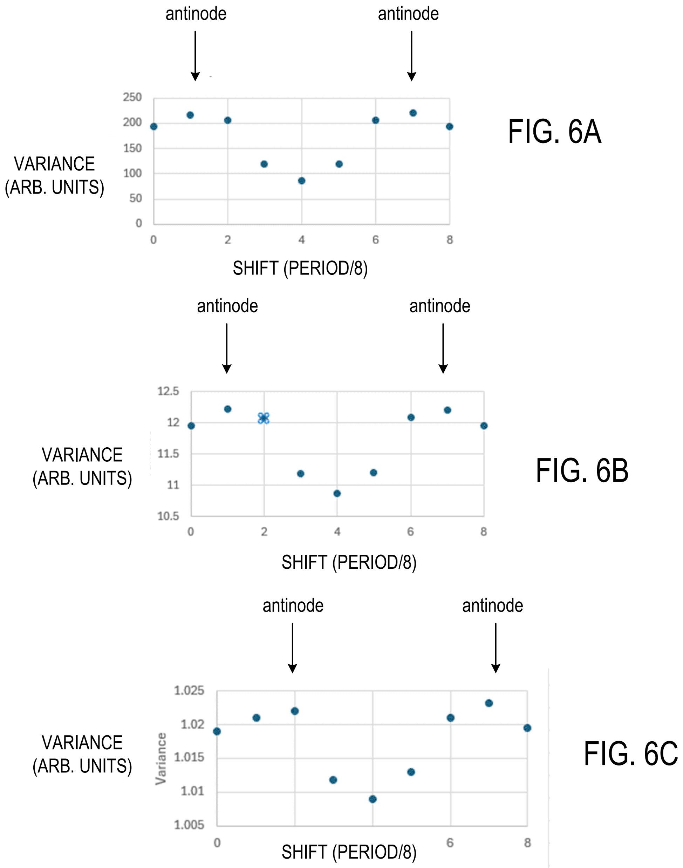

FIGS. 6A-6C are graphs of the variance of simulated cryo-EM images as a function of transverse offset of the CPB axis associated with an undeviated CPB component at a diffraction plane with phase modulation provided by a standing wave optical field of a laser phase plate. In FIG. 6A, an average number of electrons per pixel is 100, 2048 image pixels are used, and there is assumed to be no noise in the detected image intensities. In FIG. 6B, an average number of electrons per pixel is 10, 2024 image pixels are used, and shot noise is added to the image intensities. In FIG. 6C, an average number of electrons per pixel is 1, 2048 image pixels are used, and shot noise is added to the image intensities. As will be appreciated, even though variance magnitude changes considerably from a range of about 50-250 in FIG. 6A to a range of about 1.005 to 1.025 in FIG. 6C, peaks of image contrast are apparent and occur at the same locations. These peaks correspond to CPB axes at or near antinodes of the periodic phase. Thus, for wide ranges of imaging conditions, variance permits assessment of CPB axis location at the laser phase plate and can be used to adjust or control CPB axis position at the laser phase plate. In the examples of FIGS. 6A-6C, the CPB axis is preferably adjusted to be at one of the locations associated with the highest value of variance (highest contrast).

### Example 7

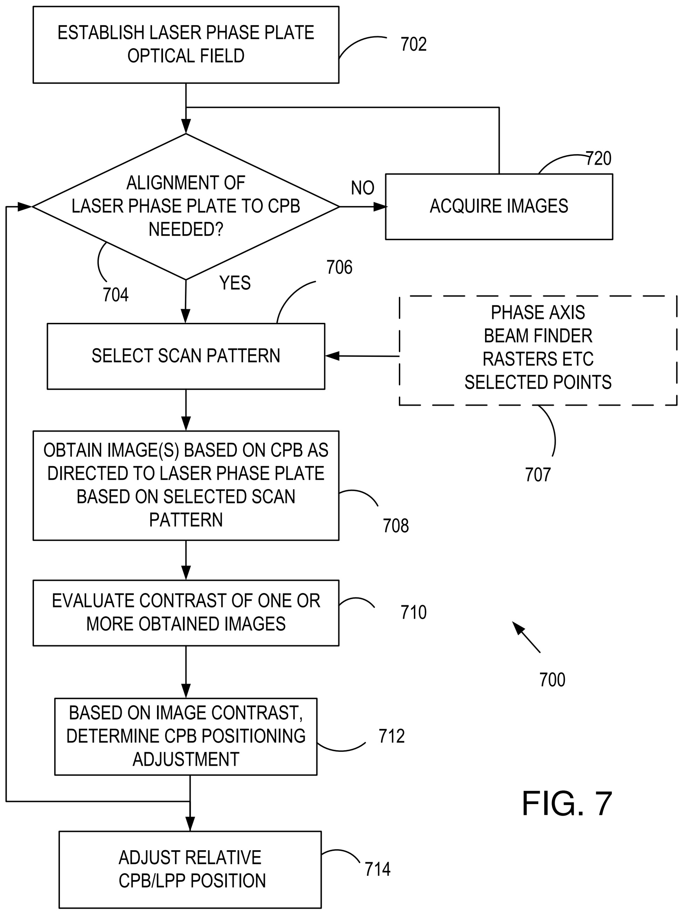

Referring to FIG. 7, representative method 700 includes establishing a standing wave optical field in a laser phase plate at 702 and determining if alignment of a CPB axis with respect to the standing wave optical field and the associated phase is required at 704. If the alignment is satisfactory, images are acquired at 720. If alignment is needed as determined at 704, a scan pattern is selected at 706 so that an undeviated CPB component can be directed to one or more locations in the standing wave optical field associated with the laser phase plate. One or more scan patterns can be stored in and retrieved from a processor readable storage device as indicated at 707. One or more scan locations can be selected and can be distributed in one or both directions in a diffraction plane. As discussed above, larger scan patterns can be used to find standing wave optical field locations with the beam Rayleigh range to find high intensity regions. If the location of the phase axis is known, smaller patterns that extend along the phase axis can be used. With any such scan patterns, the CPB can be properly aligned with respect to the standing wave optical field at a diffraction plane. At 708, images associated with the locations specified by the scan pattern are obtained and at 710, image contrast for one or more of the acquired images is obtained. At 712, a transverse offset of the CPB axis, and the standing wave optical field is determined based on the image contrast and a preferred location, i.e., at an antinode of the phase pattern or other location. At 714, a relative position of the CPB axis and the standing wave optical field is adjusted based on the transverse offset obtained using image contrast. Upon making this adjustment, alignment can be checked at 704 before beginning image acquisition or image acquisition at 720 can be initiated.

### Example 8

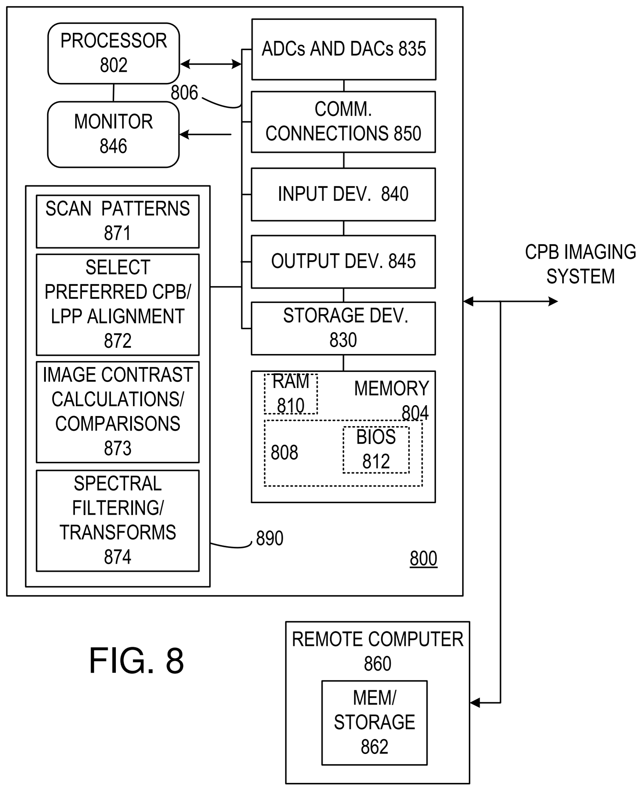

FIG. 8 and the following discussion are intended to provide a brief, general description of an exemplary computing environment in which the disclosed technology may be implemented. In particular, some or all portions of this computing environment can be used with the above methods and apparatus to, for example, control CPB positioning, focus, and diffraction plane displacement, process images to determine contrast, and select CPB/laser phase plate alignment, and generally control and process data associated with the disclosed methods and apparatus. Although not required, the disclosed technology is described in the general context of computer-executable instructions, such as program modules, being executed by a personal computer (PC). Generally, program modules include routines, programs, objects, components, data structures, etc., that perform particular tasks or implement particular abstract data types. Moreover, the disclosed technology may be implemented with other computer system configurations, including hand-held devices, multiprocessor systems, microprocessor-based or programmable consumer electronics, network PCs, minicomputers, mainframe computers, and the like as well as with FPGAs, ASICs, Complex Programmable Logic Devices (CPLDs), or other dedicated processors. The disclosed technology may also be practiced in distributed computing environments where tasks are performed by remote processing devices that are linked through a communications network. In a distributed computing environment, program modules may be located in both local and remote memory storage devices. As used herein, storage and storage devices refer to physical devices and not transitory storage or signals.

With reference to FIG. 8, an exemplary system for implementing the disclosed technology includes a general-purpose computing device in the form of an exemplary conventional PC 800, including one or more processing units 802, a system memory 804, and a system bus 808 that couples various system components including the system memory 804 to the one or more processing units 802. The system bus 808 may be any of several types of bus structures including a memory bus or memory controller, a peripheral bus, and a local bus using any of a variety of bus architectures. The exemplary system memory 804 can include read only memory (ROM) 808 and random-access memory (RAM) 810 and a basic input/output system (BIOS) containing the basic routines that help with the transfer of information between elements within the PC 800, can be stored in the ROM 808.

The exemplary PC 800 further includes one or more storage devices 830 such as a hard disk drive for reading from and writing to a hard disk, a magnetic disk drive for reading from or writing to a removable magnetic disk, and an optical disk drive for reading from or writing to a removable optical disk (such as a CD-ROM or other optical media). Such storage devices can be connected to the system bus 808 by a hard disk drive interface, a magnetic disk drive interface, and an optical drive interface, respectively. The drives and their associated computer-readable media provide nonvolatile storage of computer-readable instructions, data structures, program modules, and other data for the PC 800. Other types of computer-readable media which can store data that is accessible by a PC, such as magnetic cassettes, flash memory cards, digital video disks, CDs, DVDs, RAMs, ROMs, and the like, may also be used in the exemplary operating environment. In the example of FIG. 8, one or more memories or other storage devices 890 include portions 871, 872, 873, 874 respectively that store processor-executable instructions for selection of scan patterns, preferred CPB/LPP alignments, image contrast calculations, Fourier transforms and inverse transforms, and low pass filtering.

A number of program modules may be stored in the storage devices 830 including an operating system, one or more application programs, other program modules, and program data. For example, port location data can be stored in a storage device. A user may enter commands and information into the PC 800 through one or more input devices 840 such as a keyboard and a pointing device such as a mouse. Other input devices may include a digital camera, microphone, joystick, game pad, satellite dish, scanner, or the like. These and other input devices are often connected to the one or more processing units 802 through a serial port interface that is coupled to the system bus 808 but may be connected by other interfaces such as a parallel port, game port, or universal serial bus (USB). A monitor 848 or other type of display device is also connected to the system bus 808 via an interface, such as a video adapter. Other input and output devices 835 such as digital-to-analog converters (DACs) and analog-to-digital convertors (ADCs) may be included to provide control signals such as focus or other signals and receive signals from a CPB imaging apparatus.

The PC 800 may operate in a networked environment using logical connections to one or more remote computers, such as a remote computer 880. In some examples, one or more network or communication connections 850 are included for wired or wireless communication as well as data acquisition and control such as digital-to-analog convertors and analog-to-digital convertors. The remote computer 880 may be another PC, a server, a router, a network PC, or a peer device or other common network node, and typically includes many or all of the elements described above relative to the PC 800, although only a memory or storage device 882 has been illustrated in FIG. 8. The personal computer 800 and/or the remote computer 880 can be connected to a local area network (LAN) and a wide area network (WAN). Such networking environments are commonplace in offices, enterprise-wide computer networks, intranets, and the Internet.

When used in a LAN networking environment, the PC 800 is connected to the LAN through a network interface. When used in a WAN networking environment, the PC 800 typically includes a modem or other means for establishing communications over the WAN, such as the Internet. In a networked environment, program modules depicted relative to the personal computer 800, or portions thereof, may be stored in the remote memory storage device or other locations on the LAN or WAN. The network connections shown are exemplary, and other means of establishing a communications link between the computers may be used.

### Example 9

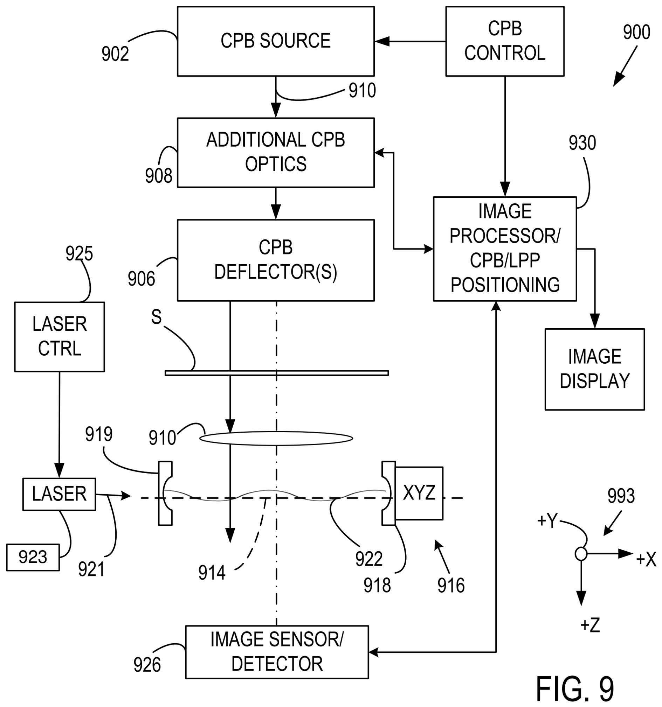

Referring to FIG. 9, a representative CPB imaging system 900 includes a CPB source 902 that produces a CPB 910 that is directed by one or more deflectors 906 and additional CPB optics 908 such as deflectors, lenses, apertures, stigmators, or other optical elements to a sample S. After modulation by the sample S, an objective lens 910 directs the CPB through a laser phase plate system 916 and images the sample S at an image sensor 926 or other detector or detection system. The objective lens 910 establishes a diffraction plane 914 shown in this example as a focal plane of the objective lens 910. The laser phase plate system 916 is based on a Fabry-Perot resonator established by mirrors 918, 919 or a ring resonator or other type of resonator or optical cavity that increases optical field intensity. A laser system such as laser and fiber amplifier 923 as controlled by a control system 925 is operable to produce an optical beam 921 that is directed into the Fabry-Perot resonator to establish a standing wave optical field 922. The control system 925 can measure and adjust the laser system 923 and other parameters to stabilize the standing wave optical field 922. In addition, the relative transverse offset of the standing wave optical field 922 with respect to the CPB along X- and Y-axes of a coordinate system 993 in the diffraction plane 914 can be adjusted using one or more actuators coupled to a control system 930, but generally control of CPB position with a beam deflector such as the CPB deflector 906 or other CPB optical element is more convenient. In some cases, additional transfer optical elements can be provided and one or more CPB beam deflectors situated to adjust CPB position with respect the standing wave optical field 922. The control system is also operational for CPB/phase plate positioning and contrast calculations.

The standing wave optical field 922 is schematically represented to show locations of nodes and antinodes. A spatial extent of the standing wave optical field 922 along the Z-axis corresponds to the beam mode, typically a lowest order Gaussian beam mode characterized by a beam waist. The standing wave optical field 922 is situated at the diffraction plane 914 but can be displaced from the diffraction plane 914 as disclosed in Buijsse, U.S. Patent Application 19/005,530, filed 30 December 2024, which is co-pending and incorporated herein by reference.

### Example 10

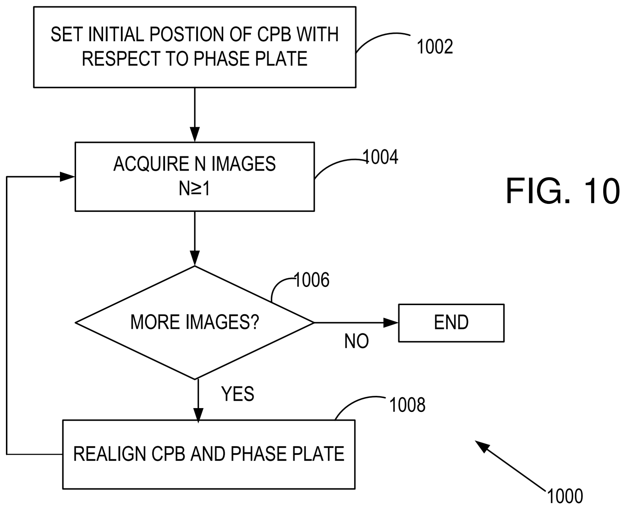

Referring to FIG. 10, a representative method 1000 includes establishing an initial position CPB with respect to a phase plate at 1002. *N* or more images, wherein *N* is an integer greater than or equal to one are acquired at 1004 followed by determining if additional images are to be acquired at 1006. If additional images are to be obtained, the CPB and phase plate can be re-aligned as needed or desirable at 1008 and images acquired again at 1004. This alignment process can be implemented so that normal imaging workflow is not appreciably slowed. For this reason, it is convenient to synchronize camera read-out of *N* consecutive frames with the deflector that is used to steer the CPB to maintain or restore CPB/phase plate alignment so that after acquisition of N images, the CPB is moved or CPB/phase plate positioning is otherwise adjusted.

### Example 11

While variations in image contrast such as a variance of image intensity are suitable guides for CPB/phase plate alignment, image contrast and image intensity variations are also dependent on image focus and defocus. FIG. 11E illustrates image intensity variance as a function of image number for a series of phase images. FIGS. 11A, 11B, 11C, 11D illustrate representative images associated with image intensity variances 1102, 1103, 1104, 1105, respectively, shown in FIG. 11E. The phase images of FIGS. 11A, 11C are satisfactory but image contrast is substantially reduced in FIGS. 11C, 11D even though the image intensity variance for these images is only about 10% less than that associated with the images of FIGS. 11A and 11C. In some cases, these variances can be associated with either defocus or with CPB/phase plate misalignment.

For the reasons above, other approaches to determining image characteristics for phase plate alignment can be useful, especially those based on image spectra. FIGS. 12A-12B illustrate respective diffractograms (spectral images) based on phase images with a laser phase plate with a CPB aligned at an antinode (FIG. 12A) and at a node (FIG. 12B). In FIG. 12A, diffraction rings such as rings 1202 are associated with features of a specimen while a region 1204 exhibiting fringes 1204 is associated with CPB/laser phase plate alignment. In FIGS. 12A-12B, a standing wave optical field is aligned along a phase axis 1211 and the fringes of region 1204 are periodic along this axis. Superior phase contrast images are obtained with a phase plate aligned to produce large amplitude differences (fringe depths or modulations) and the spectral amplitudes of FIG. 12A can be used to align or realign a CPB and phase plate or maintain CPB/phase plate alignment. For such purposes, the diffraction rings 1202 are associated with diffractogram intensity variations that are not useful in alignment but contain considerable intensity variation that can complicate assessment of fringe modulation. FIG. 12B corresponds to the diffractogram of FIG. 12A with low pass filtering applied to enhance fringe contrast in a central (lower frequency) region 1206 which in this example, surrounds the region 1204. A low pass filter frequency can be set at, for example, a frequency *f_{node}* associated with a first node 1208 in the diffractograms, or at other frequencies such as 0.25, 0.50, 0.75, 1.0, 1.25, 1.50. or 2.0 *f_{node}* or other frequencies to enhance contrast.

While filtered (or unfiltered) spectra can be used to assess CPB/phase plate alignment, in some examples, filtered spectra are Fourier transformed to produce specimen images. Filtered spectra tend to produce specimen images with image intensity variations that lack at least some of variability associated with higher frequency components. For example, FIG. 12C corresponds to image intensity variance for a number of images based on unfiltered spectra such as shown in the diffractogram of FIG. 12A. FIG. 12D corresponds to image intensity variance for a number of images based on spectral filtering such as shown in FIG. 12B. Peaks and valleys of image intensity variance are much easier to distinguish in FIG. 12D using the filtered spectra.

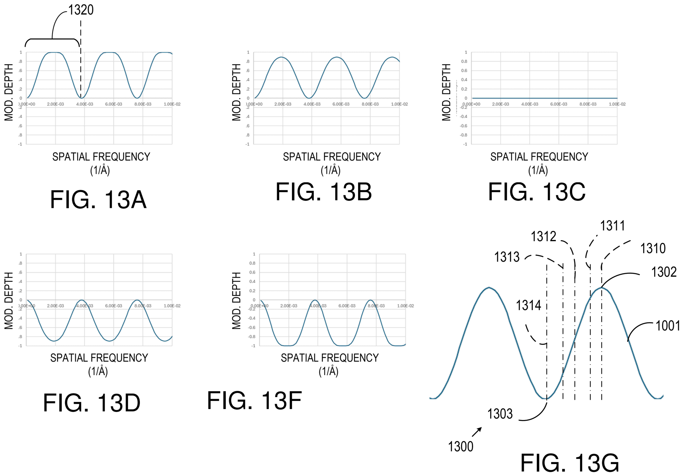

Spatial frequency amplitudes for images obtained with various CPB/phase plate alignments are shown in FIGS. 13A-13F, each of which is associated with a respective CPB/phase plate alignment 1310, 1311, 1312, 1313, 1314 with respect to a periodic phase modulation 1300 having a node 1303 and an antinode 1302 as shown in FIG. 13G. For example, FIG. 13A illustrates spatial frequency amplitude as a function of spatial frequency with CPB alignment at CPB location 1310, i.e., at an antinode. Spectral amplitudes as shown in FIG. 13A (antinode) and FIG. 13F (associated with a node) produce superior image phase contrast. In FIGS. 13D-13F, image contrast is reversed and spatial frequency amplitudes are shown with an opposite sign. Spatial frequency amplitude or a function of spatial frequency amplitude such amplitude squared, absolute value, or other functions, at one or more spatial frequences or in a suitable frequency or a sum of spatial frequency amplitudes or a function or functions of spatial frequency amplitudes in suitable ranges can be used to assess CPB/phase plate alignment. For example, spatial frequency amplitude(s) in spatial frequency range 1320 as shown in FIG. 13A can be used as frequencies outside of this range tend to be indicative of specimen features and are less useful in assessing CPB/phase plate alignment. As noted above, these frequencies can be removed by filtering to produce spectra in which CPB/phase plate alignments are more readily apparent. With CPB alignment to a laser phase plate antinode (FIG. 13A), these spectral frequency amplitudes are larger than with other CPB/phase plate alignments. A portion or all of the spatial frequency range 1320 can be used.

With a CPB aligned at an antinode as in FIG. 13A, any displacement of the CPB from the antinode reduces spatial frequency amplitudes and the decrease does not provide an indication of a direction of the displacement. By aligning the CPB/phase plate with an offset from the antinode such as at an alignment between 1310 and 1311, a displacement towards the antinode 1302 increases spatial frequence amplitudes and a displacement towards 1311 (or towards the node 1303) decreases spatial frequency amplitudes. Such increases or decreases thus determine not only a magnitude of displacement but also a direction of displacement which permit re-alignment of the CPB/phase plate.

### Example 12

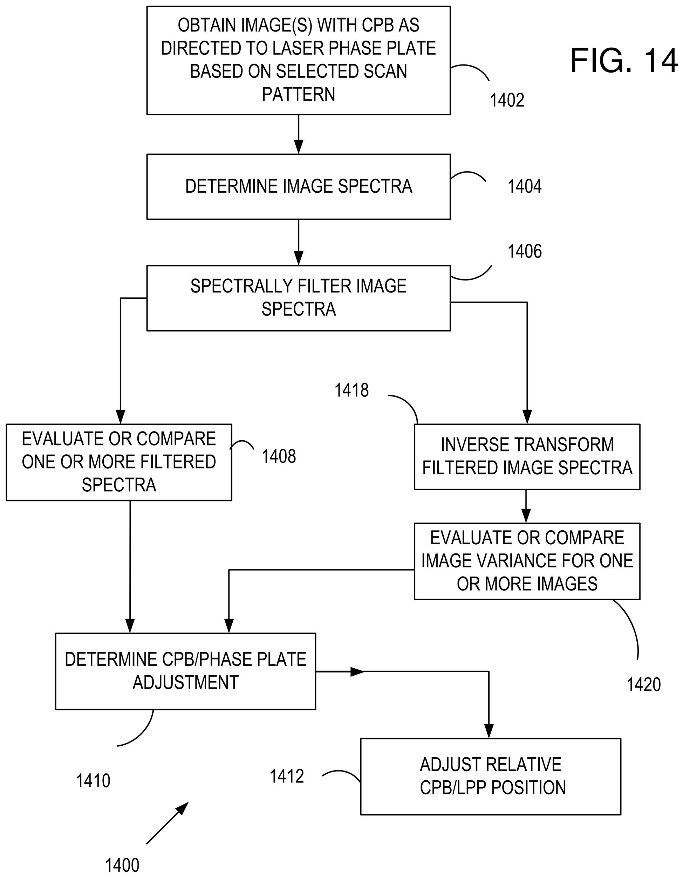

Referring to FIG. 14, a representative method 1400 of aligning and maintaining CPB/phase plate alignment (e.g., aligning a CPB to an antinode of a standing wave optical field) includes acquiring one or more images with one or more different CPB/phase plate alignments at 1402 such as alignments associated with a scan of the CPB or displacements of the phase plate. At 1404, the some or all of the images are processed to obtain respective spatial frequency spectra along at least one axis of the images, typically along a phase axis. At 1406, the spatial frequency spectra are spectrally filtered, and at 1408, the filtered spectra are evaluated or compared. Based on the comparison or evaluation, a CPB/phase plate adjustment is determined at 1410 and applied at 1412 to return the CPB/phase alignment to a preferred alignment. Comparisons of spectra can be based on spectral amplitudes at particular frequencies or in particular frequency ranges, a sum of spectral amplitudes, or functions of spectral amplitudes. In the examples based on a laser phase plate, CPB alignment with an antinode is generally preferred, but the disclosed methods permit alignment with any feature of the standing wave optical field. It will be appreciated that combinations of image intensity and spectral amplitudes can be used for CPB/phase plate alignment, and that the method 700 of FIG. 7 can use spectral features as well as image contrast for adjusting and establishing CPB/phase plate alignment.

Alternatively or additionally, the filtered spectra can be inverse Fourier transformed at 1418 and images based on the transformed, filtered spectra evaluated to assess CPB/phase plate alignment at 1420 using image intensity variance. A CPB/phase plate adjustment is then determined at 1410 and applied at 1412.

### Claim Paragraphs

Paragraph 1 is a method, including: establishing a CPB axis with respect to a phase plate to be at a selected offset from an axis of a phase plate; obtaining an image of a specimen based on the CPB passing the phase plate with the CPB axis at the selected offset; and based on a contrast of the image of the specimen, determining an offset correction from the selected offset.

Paragraph 2 includes the subject matter of any of Paragraph 1, and further includes adjusting a position of the CPB axis at the phase plate based on the determined offset correction by adjusting the CPB axis or by adjusting a position of the phase plate.

Paragraph 3 includes the subject matter of any of Paragraphs 1-2, and further includes adjusting a position of the CPB axis at the phase plate with at least one CPB deflector.

Paragraph 4 includes the subject matter of any of Paragraphs 1-3, wherein the at least one CPB deflector is configured to provide a CPB tilt at the specimen with respect to an undeflected CPB beam axis so that the CPB is incident to the specimen at a location associated with the undeflected CPB axis.

Paragraph 5 includes the subject matter of any of Paragraphs 1-4, and further specifies that the CPB deflector includes a first deflector and a second deflector, wherein the first deflector is operable to deflect a CPB away from the established CPB axis by a first angle and the second deflector is operable to deflect the CPB by a second angle toward the established CPB axis.

Paragraph 6 includes the subject matter of any of Paragraphs 1-5, and further specifies that the phase plate is a laser phase plate.

Paragraph 7 includes the subject matter of any of Paragraphs 1-6, and further specifies that the selected offset of the laser phase plate is less than P/8 from an antinode of a standing wave optical field defined with the laser phase plate, wherein P is a period of a periodic CPB phase shift associated with the standing wave optical field.

Paragraph 8 includes the subject matter of any of Paragraphs 1-7, and further specifies that the selected offset of the laser phase plate is between P/8 and P/4 from an antinode of a standing wave optical field defined with the laser phase plate, wherein P is a period of a periodic CPB phase shift associated with the standing wave optical field.

Paragraph 9 includes the subject matter of any of Paragraphs 1-8, and further specifies that the laser phase plate is situated proximate a diffraction plane associated with of conjugate to a back focal plane of an objective lens.

Paragraph 10 includes the subject matter of any of Paragraphs 1-9, and further specifies that the contrast of the image of the specimen is based on a mean value of a deviation from a mean of image intensity.

Paragraph 11 includes the subject matter of any of Paragraphs 1-10, and further specifies that the contrast of the image of the specimen is based on a mean square value of a deviation from a mean of image intensity.

Paragraph 12 includes the subject matter of any of Paragraphs 1-11, and further includes low pass filtering the image of the specimen to increase image contrast.

Paragraph 13 includes the subject matter of any of Paragraphs 1-12, and further includes: directing the CPB along at least two axes to respective locations with respect to the axis of the phase plate; obtaining specimen images with the CPB associated with the at least two axes; and determining image contrast for each of the specimen images, wherein the offset correction from the selected offset is based on the determined contrasts.

Paragraph 14 includes the subject matter of any of Paragraphs 1-13, and further includes adjusting a position of the CPB axis at the phase plate based on the determined offset correction by adjusting the CPB axis or by adjusting a position of the phase plate.

Paragraph 15 includes the subject matter of any of Paragraphs 1-14, and further includes: directing the CPB along a plurality of axes defined by a scan pattern toward respective locations with respect to the axis of the phase plate; obtaining specimen images with the CPB associated with the at least two of the plurality of axes; and determining image contrast for each of the specimen images, wherein the offset correction from the selected offset is based on the determined contrasts.

Paragraph 16 includes the subject matter of any of Paragraphs 1-15, and further specifies that the scan pattern is a raster scan pattern or a spiral scan pattern.

Paragraph 17 includes the subject matter of any of Paragraphs 1-16, and further specifies that the phase plate is a laser phase plate and the scan pattern produces CPB axes that extend further in a direction orthogonal to a phase axis of the laser phase plate than in a direction parallel to the phase axis.

Paragraph 18 includes the subject matter of any of Paragraphs 1-17, and further specifies that the phase plate is a laser phase plate defined a standing wave optical field that produces a periodic phase shift of period P along a phase axis, and wherein the scan pattern produces CPB axes that extend less than 2P in a direction parallel to a phase axis.

Paragraph 19 includes the subject matter of any of Paragraphs 1-18, and further specifies that the selected offset is zero offset.

Paragraph 20 is a charged-particle beam (CPB) imaging system, including: a CPB source operable to direct a CPB to a specimen; a phase plate situated to receive the CPB from the specimen; a detection system that receives the CPB from the phase plate and produces a specimen image based on the phase applied by the phase plate; and a controller operable to direct a selected deviated CPB component produced by the specimen from the CPB to a plurality of locations at the phase plate and based on associated images, establish a phase provided by the phase plate to the deviated component.

Paragraph 21 includes the subject matter of Paragraph 20, and further includes at least one CPB beam deflector, wherein the controller is operable to direct the selected deviated CPB component to the plurality of locations at the phase plate with the beam deflector.

Paragraph 22 includes the subject matter of any of Paragraphs 20-21, and further specifies that the CPB beam deflector is operable to produce a pure CPB tilt at the specimen.

Paragraph 23 includes the subject matter of any of Paragraphs 20-22, and further includes an objective lens situated to produce an image of the specimen, wherein the phase plate is situated at proximate a back focal plane of the objective lens or at a plane optically conjugate to a back focal plane.

Paragraph 24 includes the subject matter of any of Paragraphs 20-23, and further includes at least one actuator coupled to the phase plate, wherein the controller is operable to direct the selected deviated CPB component to the plurality of locations at the phase plate with the at least one actuator.

Paragraph 25 includes the subject matter of any of Paragraphs 20-24, and further specifies that the phase plate is a laser phase plate and the controller is operable to direct a selected deviated CPB component to an antinode of a periodic phase produced by the laser phase plate.

Paragraph 26 includes the subject matter of any of Paragraphs 20-25, and further specifies that the phase plate is a laser phase plate and the controller is operable to direct the selected deviated CPB component to have an offset bias from an antinode of a periodic phase produced by the laser phase plate.

Paragraph 27 includes the subject matter of any of Paragraphs 1-26, and further specifies that the offset correction is based on the portion of the spectrum of the image, and further includes adjusting a position of the CPB axis at the phase plate based on the determined offset correction by adjusting the CPB axis or by adjusting a position of the phase plate.

Paragraph 28 includes the subject matter of any of Paragraphs 1-27, and further includes adjusting a position of the CPB axis at the phase plate with at least one CPB deflector.

Paragraph 29 includes the subject matter of any of Paragraphs 1-28, and further specifies that the at least one CPB deflector is configured to provide a CPB tilt at the specimen with respect to an undeflected CPB beam axis so that the CPB is incident to the specimen at a location associated with the undeflected CPB axis.

Paragraph 30 includes the subject matter of any of Paragraphs 1-29, and further specifies that the CPB deflector includes a first deflector and a second deflector, wherein the first deflector is operable to deflect a CPB away from the established CPB axis by a first angle and the second deflector is operable to deflect the CPB by a second angle toward the established CPB axis.

Paragraph 31 includes the subject matter of any of Paragraphs 1-30, and further specifies that the phase plate is a laser phase plate.

Paragraph 32 includes the subject matter of any of Paragraphs 1-31, and further specifies that the selected offset of the laser phase plate is less than P/8 from an antinode of a standing wave optical field defined with the laser phase plate, wherein P is a period of a periodic CPB phase shift associated with the standing wave optical field.

Paragraph 33 includes the subject matter of any of Paragraphs 1-32, and further specifies that the selected offset of the laser phase plate is between P/8 and P/4 from an antinode of a standing wave optical field defined with the laser phase plate, wherein P is a period of a periodic CPB phase shift associated with the standing wave optical field.

Paragraph 34 includes the subject matter of any of Paragraphs 1-33, and further specifies that the laser phase plate is situated proximate a diffraction plane associated conjugate to a back focal plane of an objective lens.

Paragraph 35 includes the subject matter of any of Paragraphs 1-34, and further specifies that the contrast of the image of the specimen is based on an absolute value or square of at least one spectral component of the spectrum of the image.

Paragraph 36 includes the subject matter of any of Paragraphs 1-35, and further includes low pass filtering the image spectrum and evaluating CPB/phase plated alignment based on the filtered image.

Paragraph 37 includes the subject matter of any of Paragraphs 1-36, and further includes: directing the CPB along at least two axes to respective locations with respect to the axis of the phase plate; obtaining specimen images with the CPB associated with the at least two axes; and determining spectral amplitudes for each of the specimen images, wherein the offset correction from the selected offset is based on the spectral amplitudes.

Paragraph 38 includes the subject matter of any of Paragraphs 1-37, and further includes adjusting a position of the CPB axis at the phase plate based on the determined offset correction by adjusting the CPB axis or by adjusting a position of the phase plate.

Paragraph 39 includes the subject matter of any of Paragraphs 1-38, and further includes: directing the CPB along a plurality of axes defined by a scan pattern toward respective locations with respect to the axis of the phase plate; obtaining specimen images with the CPB associated with the at least two of the plurality of axes; and determining spectral amplitudes for each of the specimen images, wherein the offset correction from the selected offset is based on the determined spectral amplitudes.

Paragraph 40 includes the subject matter of any of Paragraphs 1-39, and further specifies that the scan pattern is a raster scan pattern or a spiral scan pattern.

Paragraph 41 includes the subject matter of any of Paragraphs 1-40, and further specifies that the phase plate is a laser phase plate and the scan pattern produces CPB scan axes that extend further in a direction orthogonal to a phase axis of the laser phase plate than in a direction parallel to the phase axis.

Paragraph 42 includes the subject matter of any of Paragraphs 1-41, and further specifies that the phase plate is a laser phase plate defining a standing wave optical field that produces a periodic phase shift of period P along a phase axis, and wherein the scan pattern produces CPB axes that extend less than 2P in a direction parallel to a phase axis.

Paragraph 43 includes the subject matter of any of Paragraphs 1-42, and further specifies that the selected offset is zero offset.

Paragraph 44 includes the subject matter of any of Paragraphs 1-43, and further specifies that the controller is operable to obtain a spectrum of the at least one specimen image and establish the phase provided by the phase plate to the deviated CPB component based on the spectrum. and further includes at least one CPB beam deflector, wherein the controller is operable to direct the selected deviated CPB component to the plurality of locations at the phase plate with the CPB beam deflector.

Paragraph 45 includes the subject matter of any of Paragraphs 1-44, and further specifies that the CPB beam deflector is operable to produce a pure CPB tilt at the specimen.

Paragraph 46 includes the subject matter of any of Paragraphs 1-45, and further includes an objective lens situated to produce an image of the specimen, wherein the phase plate is situated at proximate a back focal plane of the objective lens or at a plane optically conjugate to a back focal plane.

Paragraph 47 includes the subject matter of any of Paragraphs 1-46, and further includes at least one actuator coupled to the phase plate, wherein the controller is operable to direct the selected deviated CPB component to the plurality of locations at the phase plate with the at least one actuator.

Paragraph 48 includes the subject matter of any of Paragraphs 1-47, and further specifies that the phase plate is a laser phase plate and the controller is operable to direct a selected deviated CPB component to an antinode of a periodic phase produced by the laser phase plate.

Paragraph 49 includes the subject matter of any of Paragraphs 1-48, and further specifies that the phase plate is a laser phase plate and the controller is operable to direct the selected deviated CPB component to have an offset bias from an antinode of a periodic phase produced by the laser phase plate.

In view of the many possible embodiments to which the principles of the disclosed technology may be applied, it should be recognized that the illustrated embodiments are only preferred examples and should not be taken as limiting in scope.

Further aspects of the present disclosure are set forth in the following numbered clauses:
Clause 1. A method, comprising:
   establishing a CPB axis with respect to a phase plate to be at a selected offset from an axis of the phase plate;
   obtaining an image of a specimen based on a CPB passing the phase plate with the CPB axis at the selected offset; and
   based on a contrast of the image of the specimen or at least a portion of a spectrum of the image, determining an offset correction from the selected offset.
Clause 2. The method of clause 1, further comprising adjusting a position of the CPB axis at the phase plate based on the determined offset correction by adjusting the CPB axis or by adjusting a position of the phase plate.
Clause 3. The method of clause 1, further comprising adjusting a position of the CPB axis at the phase plate with at least one CPB deflector.
Clause 4. The method of clause 3, wherein the at least one CPB deflector is configured to provide a CPB tilt at the specimen with respect to an undeflected CPB beam axis so that the CPB is incident to the specimen at a location associated with the undeflected CPB axis.
Clause 5. The method of clause 3, wherein the CPB deflector includes a first deflector and a second deflector, wherein the first deflector is operable to deflect a CPB away from the established CPB axis by a first angle and the second deflector is operable to deflect the CPB by a second angle toward the established CPB axis.
Clause 6. The method of clause 1, wherein the phase plate is a laser phase plate.
Clause 7. The method of clause 6, wherein the selected offset of the laser phase plate is less than P/8 from an antinode of a standing wave optical field defined with the laser phase plate, wherein P is a period of a periodic CPB phase shift associated with the standing wave optical field.
Clause 8. The method of clause 6, wherein the selected offset of the laser phase plate is between P/8 and P/4 from an antinode of a standing wave optical field defined with the laser phase plate, wherein P is a period of a periodic CPB phase shift associated with the standing wave optical field.
Clause 9. The method of clause 6, wherein the laser phase plate is situated proximate a diffraction plane conjugate to a back focal plane of an objective lens.
Clause 10. The method of clause 1, wherein the contrast of the image of the specimen is based on a mean value of a deviation from a mean of image intensity.
Clause 11. The method of clause 1, wherein the contrast of the image of the specimen is based on a mean square value of a deviation from a mean of image intensity.
Clause 12. The method of clause 11, further comprising low pass filtering the image of the specimen to increase image contrast.
Clause 13. The method of clause 1, further comprising:
   directing the CPB along at least two axes to respective locations with respect to the axis of the phase plate;
   obtaining specimen images with the CPB associated with the at least two axes; and
   determining image contrast for each of the specimen images, wherein the offset correction from the selected offset is based on the determined image contrasts.
Clause 14. The method of clause 13, further comprising adjusting a position of the CPB axis at the phase plate based on the determined offset correction by adjusting the CPB axis or by adjusting a position of the phase plate.
Clause 15. The method of clause 1, further comprising:
   directing the CPB along a plurality of axes defined by a scan pattern toward respective locations with respect to the axis of the phase plate;
   obtaining specimen images with the CPB associated with the at least two of the plurality of axes; and
   determining image contrast for each of the specimen images, wherein the offset correction from the selected offset is based on the determined image contrasts.
Clause 16. The method of clause 15, wherein the scan pattern is a raster scan pattern or a spiral scan pattern.
Clause 17. The method of clause 15, wherein the phase plate is a laser phase plate and the scan pattern produces CPB scan axes that extend further in a direction orthogonal to a phase axis of the laser phase plate than in a direction parallel to the phase axis.
Clause 18. The method of clause 15, wherein the phase plate is a laser phase plate defining a standing wave optical field that produces a periodic phase shift of period P along a phase axis, and wherein the scan pattern produces CPB scan axes that extend less than 2P in a direction parallel to the phase axis.
Clause 19. The method of clause 1, wherein the selected offset is zero offset.
Clause 20. A charged-particle beam (CPB) imaging system, comprising:
   a CPB source operable to direct a CPB to a specimen;
   a phase plate situated to receive the CPB from the specimen;
   a detection system that receives the CPB from the phase plate and produces at least one specimen image based on a phase applied by the phase plate; and
   a controller operable to direct a selected deviated CPB component produced by the specimen from the CPB to a plurality of locations at the phase plate and based on the at least one specimen image, establish a phase provided by the phase plate to the deviated CPB component.
Clause 21. The CPB imaging system of clause 20, further comprising at least one CPB beam deflector, wherein the controller is operable to direct the selected deviated CPB component to the plurality of locations at the phase plate with the CPB beam deflector.
Clause 22. The CPB imaging system of clause 21, wherein the CPB beam deflector is operable to produce a pure CPB tilt at the specimen.
Clause 23. The CPB imaging system of clause 20, further comprising an objective lens situated to produce an image of the specimen, wherein the phase plate is situated at proximate a back focal plane of the objective lens or at a plane optically conjugate to the back focal plane.

## Claims

1. A method, comprising:
establishing a CPB axis with respect to a phase plate to be at a selected offset from an axis of the phase plate;
obtaining an image of a specimen based on a CPB passing the phase plate with the CPB axis at the selected offset; and
based on a contrast of the image of the specimen or at least a portion of a spectrum of the image, determining an offset correction from the selected offset.

2. The method of claim 1, further comprising adjusting a position of the CPB axis at the phase plate based on the determined offset correction by adjusting the CPB axis or by adjusting a position of the phase plate.

3. The method of claim 1 or claim 2, further comprising adjusting a position of the CPB axis at the phase plate with at least one CPB deflector; optionally:
(i) wherein the at least one CPB deflector is configured to provide a CPB tilt at the specimen with respect to an undeflected CPB beam axis so that the CPB is incident to the specimen at a location associated with the undeflected CPB axis; and/or
(ii) wherein the CPB deflector includes a first deflector and a second deflector,
wherein the first deflector is operable to deflect a CPB away from the established CPB axis by a first angle and the second deflector is operable to deflect the CPB by a second angle toward the established CPB axis.

4. The method of any preceding claim, wherein the phase plate is a laser phase plate; optionally wherein the laser phase plate is situated proximate a diffraction plane conjugate to a back focal plane of an objective lens; and/or optionally:
(i) wherein the selected offset of the laser phase plate is less than P/8 from an antinode of a standing wave optical field defined with the laser phase plate, wherein P is a period of a periodic CPB phase shift associated with the standing wave optical field; or
(ii) wherein the selected offset of the laser phase plate is between P/8 and P/4 from an antinode of a standing wave optical field defined with the laser phase plate, wherein P is a period of a periodic CPB phase shift associated with the standing wave optical field.

5. The method of any preceding claim, wherein the contrast of the image of the specimen is based on a mean value of a deviation from a mean of image intensity.

6. The method of any preceding claim, wherein the contrast of the image of the specimen is based on a mean square value of a deviation from a mean of image intensity.

7. The method of any preceding claim, further comprising low pass filtering the image of the specimen to increase image contrast.

8. The method of any preceding claim, further comprising:
directing the CPB along at least two axes to respective locations with respect to the axis of the phase plate;
obtaining specimen images with the CPB associated with the at least two axes; and
determining image contrast for each of the specimen images, wherein the offset correction from the selected offset is based on the determined image contrasts,
optionally wherein the method further comprises adjusting a position of the CPB axis at the phase plate based on the determined offset correction by adjusting the CPB axis or by adjusting a position of the phase plate.

9. The method of any preceding claim, further comprising:
directing the CPB along a plurality of axes defined by a scan pattern toward respective locations with respect to the axis of the phase plate;
obtaining specimen images with the CPB associated with the at least two of the plurality of axes; and
determining image contrast for each of the specimen images, wherein the offset correction from the selected offset is based on the determined image contrasts;
optionally wherein the scan pattern is a raster scan pattern or a spiral scan pattern.

10. The method of claim 9, wherein the phase plate is a laser phase plate and the scan pattern produces CPB scan axes that extend further in a direction orthogonal to a phase axis of the laser phase plate than in a direction parallel to the phase axis.

11. The method of claim 9 or claim 10, wherein the phase plate is a laser phase plate defining a standing wave optical field that produces a periodic phase shift of period P along a phase axis, and wherein the scan pattern produces CPB scan axes that extend less than 2P in a direction parallel to the phase axis.

12. The method of any preceding claim, wherein the selected offset is zero offset.

13. A charged-particle beam (CPB) imaging system, comprising:
a CPB source operable to direct a CPB to a specimen;
a phase plate situated to receive the CPB from the specimen;
a detection system that receives the CPB from the phase plate and produces at least one specimen image based on a phase applied by the phase plate; and
a controller operable to direct a selected deviated CPB component produced by the specimen from the CPB to a plurality of locations at the phase plate and based on the at least one specimen image, establish a phase provided by the phase plate to the deviated CPB component.

14. The CPB imaging system of claim 13, further comprising at least one CPB beam deflector, wherein the controller is operable to direct the selected deviated CPB component to the plurality of locations at the phase plate with the CPB beam deflector, optionally wherein the CPB beam deflector is operable to produce a pure CPB tilt at the specimen.

15. The CPB imaging system of claim 13 or claim 14, further comprising an objective lens situated to produce an image of the specimen, wherein the phase plate is situated at proximate a back focal plane of the objective lens or at a plane optically conjugate to the back focal plane.
